# EUROPÄISCHE PATENTSCHRIFT

(11) **EP 0 867 932 B1**
(45) Veröffentlichungstag und Bekanntmachung des Hinweises auf die Patenterteilung: **15.10.2008**
(21) Anmeldenummer: 97119991.4
(22) Anmeldetag: 14.11.1997
(51) Int. Cl.: H01L 21/607, H01L 21/60

(54) **Verfahren zur Herstellung von Bonddrahtverbindungen**
Method for making wire connections
Procédé pour la fabrication de connexions à fil

(30) Priorität: 31.01.1997 DE 19703639
(43) Veröffentlichungstag der Anmeldung: 30.09.1998
(73) Patentinhaber: ROBERT BOSCH GMBH, 70442 Stuttgart (DE)
(72) Erfinder: Sabotke, Jens, Dr., 31139 Hildesheim (DE); Schmidt, Joachim, Dr., 31141 Hildesheim (DE); Hauschild, Frank-Dieter, 31135 Hildesheim (DE)

(56) Entgegenhaltungen:
- DE-A- 3 447 345
- US-A- 5 365 409
- PATENT ABSTRACTS OF JAPAN vol. 005, no. 171 (E-080), 30. Oktober 1981 (1981-10-30) & JP 56 100436 A (TOSHIBA CORP), 12. August 1981 (1981-08-12)
- PATENT ABSTRACTS OF JAPAN vol. 004, no. 079 (E-014), 7. Juni 1980 (1980-06-07) & JP 55 046578 A (TOSHIBA CORP), 1. April 1980 (1980-04-01)

## Beschreibung

### Stand der Technik

Die Erfindung betrifft ein Verfahren zur Herstellung von Bonddrahtverbindungen mit den im Oberbegriff des Anspruchs 1 angegebenen Merkmalen.

Derartige Verfahren werden eingesetzt, um die elektrischen Anschlüsse eines auf einem Baugruppenträger plazierten elektronischen Bauelements, zum Beispiel eines Halbleiter-Chips, mit dem Leiterbahnmuster des Baugruppenträgers elektrisch zu verbinden. Dabei werden die Anschlüsse des Chips über Bonddrähte im sogenannten Ball-Wedge-Bondverfahren mit Anschlußflächen (Bondlands), welche den Leiterbahnen zugeordneten sind, verbunden. Beim Ball-Wedge-Bonden wird der Draht in einer Kapillare des Bondkopfes geführt. Ein von der Kapillare abstehendes erstes Ende des Drahtes wird z.B. durch eine Funkenentladung geschmolzen und bildet bedingt durch die Oberflächenspannung des geschmolzenen Lotes eine Kugel (Ball). Beim sogenannten Thermosonicschweißen wird beim Absenken der Kapillare auf einen Bauelementanschluß unter Druck-, Wärme und Ultraschalleinwirkung eine Schweißverbindung zwischen dem Bauelementanschluß und dem ersten Ende des Drahtes hergestellt. Anschließend wird die Kapillare zur Anschlußfläche (Bondland) einer Leiterbahn geführt, wobei der Draht aus der Kapillare herausgezogen wird. Beim Absenken der Kapillare wird das zweite Ende des Bonddrahtes durch den Kapillarenrand (Wedge) auf dem Bondland breitgequetscht und ebenfalls unter Druck-, Wärme und Ultraschalleinwirktung verschweißt und gleichzeitig von dem in der Kapillare geführten Draht abgetrennt. Nachteilig bei diesem Stand der Technik ist, daß die Herstellung der zweiten Schweißverbindung durch das Breitquetschen des Drahtes auf den Anschlußflächen sehr viel mehr Platz beansprucht als die Herstellung der Schweißverbindung zwischen den als Kugel ausgebildeten ersten Enden der Bonddrähte und den Bauelementanschlüssen. Der Abstand zwischen benachbarten Bauelementanschlüssen kann z.B. auf dem Chip bloß 80 µm betragen, während die Breite der Anschlußflächen (Bondlands) auf dem Baugruppenträger um ein vielfaches größer gewählt werden muß, damit das Bondwerkzeug auf die Anschlußfläche abgesenkt werden kann. Aus diesem Grund ist das Raster der den Leiterbahnen zugeordneten Anschlußflächen sehr viel größer als das Raster der Bauelementanschlüsse und beansprucht sehr viel mehr Platz auf dem Baugruppenträger. Weiterhin nachteilig ist, daß der Raum zwischen den Anschlußflächen der Leiterbahnen und dem Bauelement durch die Bonddrähte nur überspannt wird und deshalb ungenutzt bleibt.

Das US-Patent 5,365,409 zeigt eine Anordnung, bei welcher Anschlussflächen verwendet werden, die zwischen den Bauelementeanschlüssen und den Leiterbahnanschlüssen liegen.

### Vorteile der Erfindung

Das erfindungsgemäße Verfahren mit dem Kennzeichen des Anspruchs 1 hat demgegenüber den Vorteil, daß die für die Herstellung der elektrischen Verbindung zwischen den Anschlüssen eines Bauelements und den Leiterbahnen beim Ball-Wedge-Bonden benötigte Verdrahtungsfläche auf dem Baugruppenträger erheblich reduziert werden kann, indem die Anschlußflächen für die zweiten Enden der Bonddrähte räumlich getrennt von den Leiterbahnen zwischen dem Raster der Leiterbahnen und dem Bauelement angeordnet werden und erst über zweite Bond-drähte mit den Leiterbahnen verbunden werden, wobei die Anschlußflächen im Raum zwischen dem Bauelement und den Enden der Leiterbahnen in mehreren Reihen versetzt zueinander angeordnet werden. Auf diese Weise wird der zur Verfügung stehende ungenutzte Raum zwischen dem Bauelement und dem Leiterbahnraster besonders effizient genutzt. Vorteilhaft können nun die in Kugelform (Ball) ausgebildeten ersten Enden der Bonddrähte sowohl mit den Bauelementanschlüssen als auch mit den Leiterbahnen verbunden werden. Da das Bondwerkzeug hierfür nicht viel Platz benötigt, kann das Abstandsraster der Leiterbahnen ebenso eng ausgelegt werden, wie das Raster der Bauelementanschlüsse, also z.B. im 80 µm Raster. Gleichzeitig können die Leiterbahnen enger an das Bauelement herangeführt werden und die Bonddrahtlängen verkürzt werden. Die zweiten Enden des jeweils ersten und zweiten Bonddrahtes werden mit einer Anschlußfläche verschweißt, welche sich getrennt von den Leiterbahnen und den Bauelementanschlüssen auf dem Baugruppenträger befindet. Auf diese Weise wird auch der Raum zwischen dem Bauelement und dem Leiterbahnraster vorteilhaft genutzt.

Weiterhin ist vorteilhaft, daß mit dem erfindungsgemäßen Verfahren aufgrund der kurzen Bondwege weniger Drahtmaterial benötigt wird, was beim Golddrahtbonden die Herstellungskosten erheblich reduziert. Darüber hinaus werden die zur Herstellung von Bonddrähten ungenutzten Verfahrwege des Bondkopfes deutlich reduziert. Da bei dem erfindungsgemäßen Verfahren statt eines Bonddrahtes zwei verwandt werden, um die Verbindung von den Leiterbahnen zum Bauelement herzustellen, ist die Drahtführung der Bonddrähte insgesamt flacher, wodurch die mechanische Stabilität der Bondverbindungen erhöht wird.

Weitere vorteilhafte Ausgestaltungen werden durch die in den Unteransprüchen beschriebenen Merkmale ermöglicht. Falls der Platzbedarf für das Leiterbahnraster auf dem Baugruppenträger nicht unbedingt so klein wie möglich ausgelegt werden muß und statt dessen die Verfahrwege des Bondwerkzeugs möglichst klein gewählt werden sollen, ist es vorteilhaft, wenn nur jeder übernächste Bauelementanschluß über zwei Bonddrähte mit einer zugeordneten Leiterbahn verbunden wird und die übrigen Bauelementanschlüsse mit einer Anschlußfläche verbunden werden, die unmittelbar an die zugeordnete Leiterbahn angebunden ist.

Vorteilhaft kann die Breite einer Anschlußfläche größer ausgebildet werden als die Summe aus der Breite der zugeordneten Leiterbahn und den Abständen dieser Leiterbahn zu den auf dem Baugruppenträger direkt benachbarten Leiterbahnen.

### Zeichnung

Ein Ausführungsbeispiel der Erfindung ist in der Zeichnung dargestellt und wird in der nachfolgenden Beschreibung näher erläutert. Es zeigt
Fig. 1a eine Aufsicht auf einen Ausschnitt eines Baugruppenträger nach dem Stand der Technik,
Fig. 1b einen schematischen Querschnitt durch eine Bondverbindung der Fig. 1a,
Fig. 2a eine Aufsicht auf einen Ausschnitt eines Baugruppenträgers, welcher nach dem erfindungsgemäßen Verfahren hergestellt wurde und
Fig. 2b einen schematischen Querschnitt durch eine Bonddrahtverbindung zwischen einer Leiterbahn und einem Bauelementanschluß der Fig. 2a.

### Beschreibung des Ausführungsbeispiels

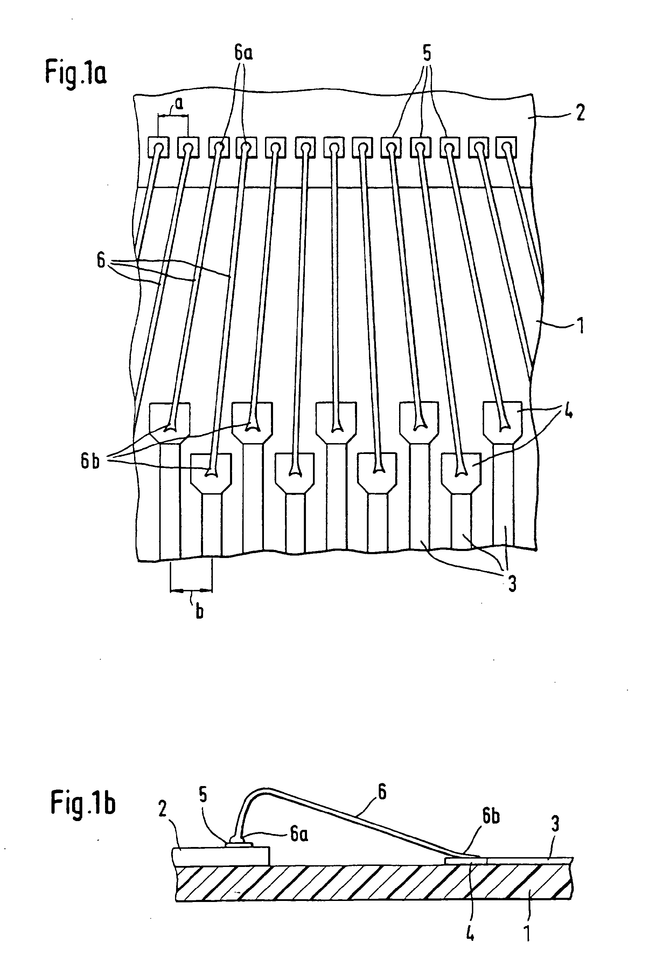

Die Figuren 1a und 1b zeigen einen Baugruppenträger 1, der dem bisher bekannten Stand der Technik entspricht. Ein solcher Baugruppenträger kann z.B. eine Leiterplatte oder ein Hybrid sein. Auf einer Hauptoberfläche des Baugruppenträgers befindet sich wenigstens ein Bauelement 2, das z.B. ein IC sein kann. Das Bauelement 2 ist auf den Baugruppenträger aufgeklebt oder in sonstiger Weise befestigt. An der von der Hauptoberfläche abgewandten Oberseite des IC's befinden sich zahlreiche Anschlüsse 5, von denen nur einige in Fig. 1a gezeigt sind. Die Anschlüsse sind auf dem IC mit einem engen Raster in einem Abstand a von nur 80 µm angeordnet. Weiterhin befindet sich ein Raster von Leiterbahnen 3 auf dieser Hauptoberfläche des Baugruppenträgers 1, an deren Enden Anschlußflächen 4 vorgesehen sind, die mit den Anschlüssen 5 des Bauelementes 2 über Bonddrähte im Ball-Wedge-Bondverfahren verbunden werden. Bei der Herstellung der Bonddrahtverbindung wird ein Bondwerkzeug benutzt, bei dem der Draht in einer Kapillare geführt wird, deren Durchmesser an den Draht angepaßt ist. Als Bonddraht wird meist Golddraht verwandt. Das Ende 6a des Drahtes unterhalb der Kapillare wird z.B. durch die Energie einer Funkenentladung geschmolzen, wobei die Schmelze bedingt durch die Oberflächenspannung eine Kugel (Ball) bildet. Beim Absenken der Kapillare auf den Bauelementanschluß 2 wird an dem Ende 6a des Bonddrahtes 6 eine Schweißverbindung durch Druck-, Wärme- und Ultraschalleinwirkung hergestellt. Anschließend wird das Bondwerkzeug zu einer Anschlußfläche 4 geführt, wobei der Draht aus der Kapillare herausgezogen wird. Beim erneuten Absenken der Kapillare auf der Anschlußfläche 4 bildet der Draht eine Schlaufenform. Die Kapillare wird nun ganz auf die Anschlußfläche abgesenkt und der Draht unter Druck-, Wärme und Ultraschalleinwirkung (Thermosonicschweißen) mit der Anschlußfläche 4 verschweißt. Dabei bildet der Kapillarenrand ein keilförmiges Schweißwerkzeug mit dem das Ende 6b des Bonddrahtes auf der Anschlußfläche breitgequetscht, verschweißt und gleichzeitig vom Draht in der Kapillare abgetrennt wird. Bei diesem Verfahrensschritt benötigt das Bondwerkzeug einen gewissen Platz auf der Anschlußfläche, so daß die Anschlußflächen nicht beliebig klein ausgelegt sein können. Die Anschlußflächen 4 sind in den Leiterbahnen 3 integriert, so daß nun ein Anschluß 5 des Bauelementes 2 mit einer Leiterbahn 3 über den Bonddraht 6 elektrisch verbunden ist. Wie besonders gut in Fig. 1a zu erkennen ist, muß das Raster der Anschlußflächen 4 mit den Leiterbahnen 3 (Abstandsmaß b) sehr viel breiter ausgeführt werden als das Raster der Bauelementanschlüsse (Abstandsmaß a). Insbesondere ist es nicht möglich die Breite der Anschlußflächen 4 größer auszugestalten als die Summe aus der Breite der jeweils zugeordneten Leiterbahn und den beiden Abständen dieser Leiterbahn zu den auf dem Baugruppenträger direkt benachbarten Leiterbahnen.

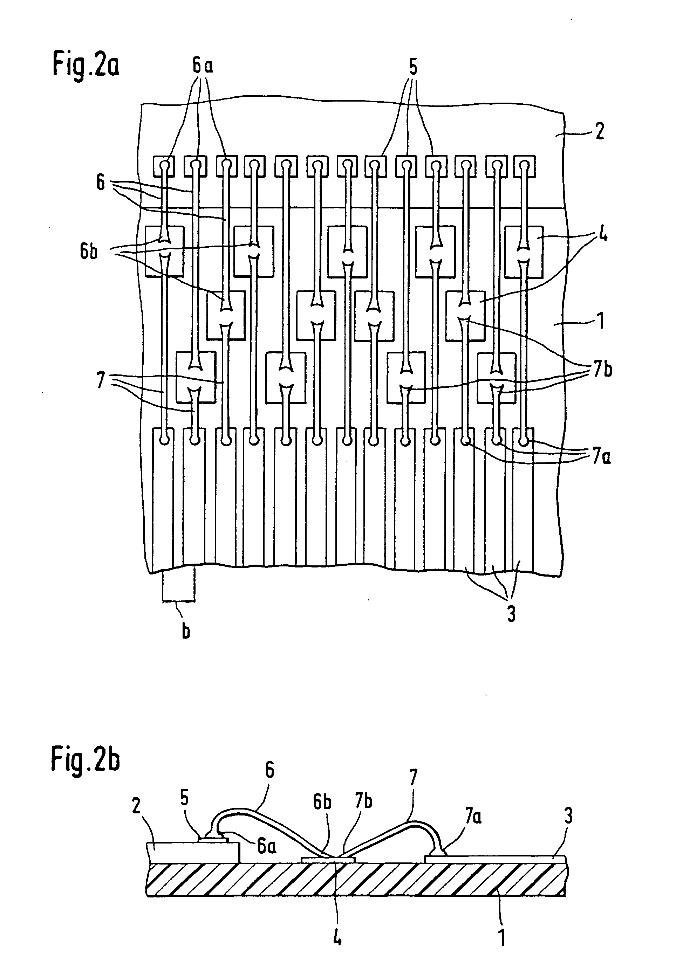

In den Figuren 2a und 2b ist ein Baugruppenträger 1 gezeigt der nach dem erfindungsgemäßen Verfahren hergestellt wurde. Die Figuren sollen nur den wesentlichen Inhalt der Erfindung deutlich machen und sind daher, was die Größenordnungen und z.B. die Länge der Bonddrähte anbelangt stark vereinfacht. Das dargestellte Leiterbahnmuster bildet wie bei der in Fig. 1a dargestellten bekannten Lösung ein Raster mit zueinander parallel verlaufenden Leiterbahnenden. Die Leiterbahnenden 3 können aber im Vergleich zu Fig. 1a sehr viel dichter an das Bauelement 2 herangeführt sein. In dem hier gezeigten Beispiel wird jeder Bauelementanschluß 5 über zwei Bonddrähte 6 und 7 mit einer Leiterbahn 3 verbunden. Dabei wird so verfahren, daß das in Kugelform (Ball) ausgestaltete erste Ende 6a eines Bonddrahtes 6 mit einem Anschluß 5 des Bauelementes 2 verschweißt wird. Anschließend wird das zweite Ende 6b des Bonddrahtes 6 auf der Anschlußfläche 4 verschweißt. Die Anschlußfläche 4 ist aber nicht in eine Leiterbahn 3 integriert, sonderen befindet sich räumlich getrennt von den Leiterbahnen 3 auf dem Flächenstück zwischen dem Bauelement 2 und dem Raster der Leiterbahnen. Nach dem Breitquetschen und Verschweißen des Endes 6b des Bonddrahtes 6a wird nun der Bondkopf zu einer Leiterbahn 3 gefahren, die mit dieser Anschlußfläche 4 verbunden werden soll. Die Leiterbahnen 3 befinden sich in einem engen Raster auf dem Baugruppenträger in einem Abstand b voneinander, welcher etwa dem Abstand a der Bauelementanschlüsse entspricht. Dies ist möglich, da bei dem in Fig. 2a gezeigten Baugruppenträger 1 die Breite einer Anschlußfläche 4 gleich oder größer als die Summe aus der Breite der zugeordneten Leiterbahn und den beiden Abständen dieser Leiterbahn zu den jeweils direkt benachbarten Leiterbahnen sein kann, ohne daß die Anschlußflächen die Leiterbahnen überlappen. Es sind aber auch größere Abstände b denkbar. Das Kugel- oder Ballförmige Ende 7a eines zweiten Bonddrahtes 7 wird nun zunächst mit der Leiterbahn 3 verschweißt. Dies ist leicht möglich, da für die Herstellung dieser Schweißverbindung nicht so viel Platz auf den Leiterbahnen beansprucht wird, wie für die Herstellung der zweiten Schweißverbindung 7b. Die Verbindung kann also auch auf sehr schmalen Leiterbahnen hergestellt werden. Anschließend wird das Bondwerkzeug zu der Anschlußfläche 4 zurückgeführt und es wird das zweite Ende 7b des Bonddrahtes 7 mit der Anschlußfläche 4 verschweißt, wobei dieses Ende nun erneut durch das Bondwerkzeug auf der Anschlußfläche 4 breitgedrückt werden kann (Wedge-Bonden). Die übrigen Anschlüsse 5 werden in gleicher Weise mit den Leiterbahnen 3 verbunden, so daß jeder Leiterbahn 3 über eine zugeordnete Anschlußfläche 4 mit einem Bauelementanschluß 5 über zwei Bonddrähte 6,7 verbunden ist. Die Bonddrähte 6 und 7 können dabei auch so geführt sein, daß sie über die Anschlußflächen benachbarter Bondrähte hinweggeführt sind. Vorteilhaft sind die Anschlußflächen 4 in dem hiergezeigten Beispiel in drei Reihen zwischen dem Bauelement 2 und dem Raster der Leiterbahnen 3 angeordnet. So wird der zur Verfügung stehende Platz optimal genutzt.

Abweichend zu dem hier gezeigten Ausführungsbeispiel ist es auch möglich, nur jeden übernächsten Bauelementanschluß 5 über zwei Bonddrähte mit einer Leiterbahn zu verbinden und die übrigen Bonddrähte, wie im Stand der Technik bekannt, mit nur einem Bonddraht mit einer Anschlußfläche zu verschweißen, die unmittelbar in eine Leiterbahn integriert ist. Bei diesem Verfahren sind die ungenutzten Verfahrwege des Bondwerkzeuges noch geringer, obwohl nun das Raster der Leiterbahnen 3 nicht ganz so eng gewählt werden kann, wie in dem ersten Ausführungsbeispiel.

## Patentansprüche

1. Verfahren zur Herstellung von Bonddrahtverbindungen zwischen den Anschlüssen (5) wenigstens eines auf einem Baugruppenträger (1) angeordneten elektrischen oder elektronischen Bauelements (2) und auf dem Baugruppenträger (1) angeordneten Leiterbahnen (3) durch Ball-Wedge-Bonden, wobei erste Enden der Bonddrähte durch das Bondwerkzeug zunächst kugelartig geformt und anschließend mit den Bauelementanschlüssen verschweißt werden und wobei zweite Enden der Bonddrähte mit dem Bondwerkzeug auf den Leiterbahnen zugeordneten Anschlussflächen breitgequetscht und festgeschweißt werden, wobei die den Leiterbahnen (3) zugeordneten Anschlussflächen (4) zwischen dem Bauelement (2) und den Leiterbahnen (3) und räumlich getrennt von den Leiterbahnen (3) angeordnet sind und wobei die Anschlussflächen (4) mit wenigstens einem Teil der Bauelementanschlüsse (5) über erste Bonddrähte (6) und mit den Leiterbahnen (3) über zweite Bonddrähte (7) verbunden werden, **dadurch gekennzeichnet, dass** jeweils das erste Ende (6a) des ersten Bonddrahtes (6) mit einem Bauelementanschluss (5) und das erste Ende (7a) des zweiten Bonddrahtes (7) mit einer Leiterbahn (3) verbunden wird und das zweite Ende (6b) des ersten Bonddrahtes (6) und das zweite Ende (7b) des zweiten Bonddrahtes (7) mit der dieser Leiterbahn zugeordneten Anschlussfläche (4) verbunden wird, indem die zweiten Enden des ersten und zweiten Bonddrahtes mit dem Bondwerkzeug auf den Leiterbahnen zugeordneten Anschlussflächen breitgequetscht und festgeschweißt werden, wobei die Anschlussflächen (4) im Raum zwischen dem wenigstens einen Bauelement (2) und den Enden der Leiterbahnen (3) in mehreren Reihen versetzt zueinander angeordnet sind.

2. Verfahren nach Anspruch 1, **dadurch gekennzeichnet, daß** jeder zweite Bauelementanschluß (5) mit einer Anschlußfläche (4) verbunden wird, die mit einer Leiterbahn (3) unmittelbar verbunden ist.

3. Baugruppenträger mit wenigstens einem auf dem Baugruppenträger (1) angeordneten elektrischen oder elektronischen Bauelement (2) und auf dem Baugruppenträger (1) angeordneten Leiterbahnen (3) mit Anschlussflächen (4), die den Leiterbahnen (3) zugeordnet sind und die zwischen dem Bauelement (2) und dem Ende der Leiterbahn (3) und räumlich getrennt von den Enden der Leiterbahn (3) angeordnet sind und die Anschlussflächen (4) mit wenigstens einem Teil der Bauelementanschlüsse (5) über erste Bonddrähte (6) und mit den Leiterbahnen (3) über zweite Bonddrähte (7) verbunden sind, **dadurch gekennzeichnet, dass** die Anschlussflächen (4) im Raum zwischen dem wenigstens einen Bauelement (2) und den Enden der Leiterbahnen (3) in mehreren Reihen versetzt zueinander angeordnet sind, die mit den Bauelementanschlüssen (5) verbundenen ersten Enden (6a) der ersten Bonddrähte (6) und die mit den Leiterbahnen (3) verbundenen ersten Enden (7a) der zweiten Bonddrähte (7) eine in der Breite kleinere Anbindungsfläche aufweisen, als die mit den Anschlussflächen (4) verbundenen zweiten Enden (6b) der ersten Drähte (6) und zweiten Enden (7b) der zweiten Drähte (7), wobei die zweiten Enden der Bonddrähte auf den den Leiterbahnen zugeordneten Anschlussflächen (4) breitgequetscht und festgeschweißt sind.

4. Baugruppenträger nach Anspruch 3, **dadurch gekennzeichnet, daß** die Breite einer Anschlußfläche (4) größer ist als die Summe aus der Breite der zugeordneten Leiterbahn (3) und den beiden Abständen dieser Leiterbahn (3) zu den auf dem Baugruppenträger (1) direkt benachbarten Leiterbahnen.

## Claims

1. Method for producing bonding wire connections between the connections (5) of at least one electrical or electronic component (2), which is arranged on a mounting rack (1), and conductor tracks (3), which are arranged on the mounting rack (1), by means of ball/wedge bonding, first ends of the bonding wires being first of all spherically shaped by the bonding tool and then being welded to the component connections, and second ends of the bonding wires being flattened and firmly welded to connection areas, which are associated with the conductor tracks, using the bonding tool, the connection areas (4) which are associated with the conductor tracks (3) being arranged between the component (2) and the conductor tracks (3) and being spatially separated from the conductor tracks (3), and the connection areas (4) being connected to at least some of the component connections (5) by means of first bonding wires (6) and being connected to the conductor tracks (3) by means of second bonding wires (7), **characterized in that** the first end (6a) of the first bonding wire (6) is respectively connected to a component connection (5) and the first end (7a) of the second bonding wire (7) is connected to a conductor track (3), and the second end (6b) of the first bonding wire (6) and the second end (7b) of the second bonding wire (7) are connected to the connection area (4) associated with this conductor track by virtue of the second ends of the first and second bonding wires being flattened and firmly welded to connection areas, which are associated with the conductor tracks, using the bonding tool, the connection areas (4) being arranged in a plurality of rows in the space between the at least one component (2) and the ends of the conductor tracks (3) such that they are offset with respect to one another.

2. Method according to Claim 1, **characterized in that** each second component connection (5) is connected to a connection area (4) which is directly connected to a conductor track (3).

3. Mounting rack having at least one electrical or electronic component (2), which is arranged on the mounting rack (1), and conductor tracks (3), which are arranged on the mounting rack (1), having connection areas (4) which are associated with the conductor tracks (3) , are arranged between the component (2) and the end of the conductor track (3), are physically separated from the ends of the conductor track (3) and are connected to at least some of the component connections (5) by means of first bonding wires (6) and to the conductor tracks (3) by means of second bonding wires (7), **characterized in that** the connection areas (4) are arranged in a plurality of rows in the space between the at least one component (2) and the ends of the conductor tracks (3) in such a manner that they are offset with respect to one another, the first ends (6a) of the first bonding wires (6), which are connected to the component connections (5), and the first ends (7a) of the second bonding wires (7), which are connected to the conductor tracks (3), have a linking area whose width is narrower than the second ends (6b) of the first wires (6), which are connected to the connection areas (4), and the second ends (7b) of the second wires (7), the second ends of the bonding wires being flattened and firmly welded to the connection areas (4) associated with the conductor tracks.

4. Mounting rack according to Claim 3, **characterized in that** the width of a connection area (4) is greater than the sum of the width of the associated conductor track (3) and the two distances between this conductor track (3) and the conductor tracks which are directly adjacent on the mounting rack (1).

## Revendications

1. Procédé de réalisation de liaisons de connexion par fil entre des bornes (5) d'au moins un composant électrique ou électronique (2) installé sur un support d'un ensemble de composants (1) et de chemins conducteurs (3) prévus sur le support d'un ensemble de composants (1) par des liaisons par boules et coins, selon lequel
les premières extrémités des fils de liaison sont tout d'abord mises en forme de billes par l'outil de liaison puis elles sont soudées aux bornes du composant et
les secondes extrémités des fils de liaison sont écrasées par l'outil de liaison sur les surfaces de connexion associées aux chemins conducteurs et elles sont solidarisées par soudage,
les surfaces de connexion (4) associées aux chemins conducteurs (3) sont prévues entre le composant (2) et les chemins conducteurs (3) en étant séparées dans l'espace des chemins conducteurs (3), et
des surfaces de connexion (4) sont reliées à au moins une partie des connexions de composant (5) par des premiers fils de liaison (6) et aux chemins conducteurs (3) par des seconds fils de liaison (7),
**caractérisé en ce que**
chaque première extrémité (6a) des premiers fils de liaison (6) est reliée à une connexion de composant (5) et la première extrémité (7a) du second fil de liaison (7) est reliée à un chemin conducteur (3),
la seconde extrémité (6b) du premier fil de liaison (6) et la seconde extrémité (7b) du second fil de liaison (7) sont reliées à une surface de connexion (4) associée à ce chemin conducteur, et
les secondes extrémités du premier et du second fil de liaison sont écrasées et sont solidarisées par soudure aux surfaces de connexion associées aux chemins conducteurs,
les surfaces de connexion (4) étant décalées les unes des autres sur plusieurs rangées dans l'espace compris entre au moins un composant (2) et les extrémités des chemins conducteurs (3).

2. Procédé selon la revendication 1,
**caractérisé en ce que**
chaque seconde connexion de composant (5) est reliée à une surface de connexion (4) directement reliée à un chemin conducteur (3).

3. Support d'un ensemble de composants comportant au moins un composant électrique ou électronique (2) installé sur le support d'un ensemble de composants (1) et de chemins conducteurs (3) prévus sur le support d'un ensemble de composants (1), ces chemins conducteurs étant munis de surfaces de connexion (4) associées aux chemins conducteurs (3) et prévues entre le composant (2) et l'extrémité du chemin conducteur (3) en étant séparées dans l'espace par rapport aux extrémités du chemin conducteur (3), et les surfaces de connexion (4) sont reliées à au moins une partie des connexions de composants (5) par des premiers fils de liaison (6) et aux chemins conducteurs (3) par des seconds fils de liaison (7),
**caractérisé en ce que**
les surfaces de connexion (4) sont prévues dans l'espace entre au moins un composant (2) et les extrémités des chemins conducteurs (3), en étant décalées en plusieurs rangées en ayant, par rapport aux premières extrémités (6a) reliées aux connexions de composants (5) des premiers fils de liaison (6) et aux premières extrémités (7a) des seconds fils de liaison (7) reliées aux chemins conducteurs (3), une première surface de fixation moins large que les secondes extrémités (6b) des premiers fils (6) reliés aux surfaces de connexion (4) et les secondes extrémités (7b) des seconds fils (7), les secondes extrémités des fils de liaison étant écrasés et solidarisés par soudage aux surfaces de connexion (4) associées aux chemins conducteurs.

4. Support d'un ensemble de composants selon la revendication (3)
**caractérisé en ce que**
la largeur d'une surface de connexion (4) est supérieure à la somme de la largeur du chemin conducteur (3) associé et des deux intervalles entre ce chemin conducteur (3) et les chemins conducteurs directement voisins sur le support d'un ensemble de composants (1).
